# EUROPÄISCHE PATENTANMELDUNG

(11) **EP 1 727 285 A1**
(43) Veröffentlichungstag der Anmeldung: **29.11.2006**
(21) Anmeldenummer: 06009796.1
(22) Anmeldetag: 12.05.2006
(51) Int. Cl.: H03K 17/18

(54) **Schaltungsanordnung mit Fehlerrückmeldung zur Ansteuerung von Leistungshalbleiterschaltern und zugehöriges Verfahren**

(30) Priorität: 23.05.2005 DE 102005023653
(71) Anmelder: SEMIKRON Elektronik GmbH & Co. KG, 90431 Nürnberg (DE)
(72) Erfinder: Pawel, Sascha, 99867 Gotha (DE); Pawel, Ilja, 99867 Gotha (DE); Herzer, Reinhard, 98693 Ilmenau (DE)

(57) **Zusammenfassung**

Die Erfindung betrifft eine integrierte Schaltungsanordnung vorgestellt zur Ansteuerung von Leistungsschaltern angeordnet in Brückenschaltung und ein zugehöriges Verfahren. Die Primärseite dieser Schaltungsanordnung ist hierbei mit der Sekundärseite, die den TOP-Schalter (50) ansteuert über einen Levelshifter (44) verbunden. Weiterhin weist die Schaltungsanordnung zwischen der Primärseite und einer Sekundärseite eine Diode (60) zur Fehlerstatusübermittlung von der Sekundärseite zur Primärseite auf. Der anodenseitige Anschluss der Diode (60) ist mit der Primärseite und deren kathodenseitiger Anschluss mit der Sekundärseite der Treiberschaltung verbunden. Die Primärseite legt an diese Diode eine Spannung an. Bei fehlerfreiem Betrieb legt die Sekundärseite an die Katode der Diode (60) "high-" Pegel (Vd) an, bei fehlerhaftem Betrieb "low-" Pegel (Vg). Der Fehlerstatus auf der Sekundärseite wird von der Primärseite dadurch erkannt wird, dass ein Stromfluss durch die Diode (60) stattfindet, da sich die Sekundärseite über den geöffneten BOT- Schalter (52) oder über einen hochohmigen Widerstand (70) annähernd auf dem Masse- Bezugspotential befindet.

## Beschreibung

Die Erfindung betrifft eine vorzugsweise integrierte Schaltungsanordnung vorgestellt zur Ansteuerung von Leistungsschaltern angeordnet in Brückenschaltung und ein zugehöriges Verfahren. Derartige Brückenanordnungen von Leistungsschaltern sind als Halb-, H- (Zweiphasen-), oder als Dreiphasenbrückenschaltungen bekannt, wobei die einphasige Halbbrücke den Grundbaustein derartiger leistungselektronischer Schaltungen darstellt. In einer Halbbrückenschaltung sind zwei Leistungsschalter, ein erster, sog. TOP-Schalter und ein zweiter sog. BOT- Schalter in einer Reihenschaltung angeordnet. Eine derartige Halbbrücke weist in der Regel eine Verbindung zu einem Gleichstromzwischenkreis auf. Die Mittelanzapfung ist typischerweise mit einer Last verbunden.

Bei Ausgestaltung der Leistungsschalter als ein Leistungshalbleiterbauelement oder mit als eine Mehrzahl parallel oder in Reihe geschalteter Leistungshalbleiterbauelemente ist zur Ansteuerung der Leistungsschalter eine Ansteuerschaltung notwendig. Derartige Ansteuerschaltungen bestehen nach dem Stand der Technik aus mehreren Teilschaltungen bzw. Funktionsblöcken. Das von einer übergeordneten Steuerung kommende Ansteuersignal wird in einer ersten Teilschaltung, der Primärseite, aufbereitet und über weitere Komponenten den Treiberschaltungen, den Sekundärseiten und schließlich dem Steuereingang des jeweiligen Leistungsschalters zugeführt. Bei Halbbrückenanordnungen mit höheren Zwischenkreisspannungen, beispielhaft größer 50V, wird die Primärseite zur Aufbereitung der Steuersignale potentialmäßig / galvanisch von der Sekundärseite getrennt, da sich die Leistungsschalter, zumindest der TOP- Schalter der Halbbrücke im Betrieb auf keinem konstanten Potential befinden und somit eine spannungsmäßige Isolation unumgänglich ist. Diese Trennung erfolgt nach dem Stand der Technik beispielhaft mittels Übertragern, Optokopplern bzw. Lichtwellenleitern. Diese galvanische Trennung wird zumindest für den TOP-Schalter, bei höheren Leistungen aber auch für den BOT- Schalter auf Grund eines möglichen Verrisses des Massepotentials beim Schalten ausgeführt.

Bekannt sind auch integrierte Schaltungsanordnungen für Leistungsschalter der Spannungsklassen bis 600V oder auch 1200V, die auf eine externe galvanische Trennung verzichten. Bei diesen monolithisch integrierte Schaltungen werden nach dem Stand der Technik so genannte Levelshifter, zumindest für den TOP- Schalter, eingesetzt, Diese elektronischen Bauelemente und lsolationstechniken überwinden somit die die Potentialdifferenz von der Primärseite zur Sekundärseite.

In dieser beschriebenen Ausgestaltung einer monolithisch integrierten Schaltungsanordnung zur Ansteuerung von Leistungsschaltern ist zumindest in der einfachsten Konfiguration für die Sekundärseite des TOP- Schalters keine Möglichkeit gegeben zur Rückmeldung eines Fehlers an die Primärseite.

Der Erfindung liegt die Aufgabe zugrunde eine vorzugsweise monolithisch integrierte Schaltungsanordnung für Leistungshalbleiterschalter in Brückenanordnung sowie ein zugehöriges Verfahren vorzustellen, welches eine Fehlerrückmeldung von der Sekundärseite zur Primärseite mittels einfacher und integrierbarer Mittel gestattet.

Die Aufgabe wird erfindungsgemäß gelöst, durch die Maßnahmen der Merkmale der Ansprüche 1 und 4. Bevorzugte Ausführungsformen sind in den Unteransprüchen beschrieben.

Der erfinderische Gedanke geht aus von einer bekannten Schaltungsanordnung zur Ansteuerung von Leistungshalbleiterschaltern in Brückentopologie bestehend aus einem primärseitigen Teil (Primärseite) und jeweils einem sekundärseitigen Teil (Sekundärseite). Die Brückenschaltung besteht aus einem ersten, dem TOP und einem zweiten den BOT- Schalter. Diese sind nach dem Stand der Technik mit einem Gleichstromzwischenkreis verbunden. Der Mittenabgriff zwischen dem TOP und dem BOT-Schalter bildet den Wechselstromausgang der Brückenschaltung. Die Schaltungsanordnung zur Ansteuerung weist auf ihrer Primärseite mindestens eine Signalverarbeitung und mindestens einen Levelshifter zur potentialfreien Ansteuerung mindestens einer Sekundärseite auf. Diese Sekundärseite weist ihrerseits mindestens eine Signalverarbeitung sowie mindestens eine Treiberstufe für den jeweiligen Schalter auf.

Die Erfindung stellt eine, vorzugsweise monolithisch integrierte, Schaltungsanordnung zur Ansteuerung von Leistungshalbleiterschaltern vor, wobei zwischen der Primärseite und mindestens einer Sekundärseite eine Diode zur Fehlerstatusübermittlung von der Sekundärseite zur Primärseite angeordnet ist. Hierbei ist der anodenseitige Anschluss der Diode zur Primärseite und der kathodenseitige Anschluss zur Sekundärseite der Treiberschaltung angeordnet. Weiterhin weist die Schaltungsanordnung auf der Primärseite eine Filterung und eine Stromerfassung zur Fehlerstatuserkennung auf sowie auf der Sekundärseite eine Schaltung zur Fehlerstatusimplementierung. Diese beiden Schaltungsteile sind mit der Diode verbunden.

Das zugehörige Verfahren zur Fehlerübermittlung von der Sekundärseite zur Primärseite in einer Schaltungsanordnung der oben genannten Art weist auf der Primärseite eine Stromerfassung sowie vorzugsweise eine Spannungsregelung auf, die eine definierte Spannung, gleich oder kleiner als die primärseitige Betriebsspannung, an die Diode anlegt.

Bei fehlerfreiem Betrieb stellt die Fehlerstatusimplementierung der einem TOP Schalter zugeordneten Sekundärseite "high-" Pegel an der Kathode der Diode ein, bei fehlerhaftem Betrieb weist diese Fehlerstatusimplementierung "low-" Pegel auf. Solange die Sekundärseite eine hohe positive Offsetspannung gegenüber der Primärseite aufweist (TOP-Schalter offen), kann kein Stromfluss stattfinden (Diode gesperrt). Bei geschlossenem TOP- Schalter und geöffneten BOT- Schalter bzw. durch einen zum BOT- Schalter parallelen hochohmigen Widerstand wird die sekundärseitige Schaltung zur Fehlerstatusimplementierung auf Masse- Bezugspotential gezogen. In diesem Fall wird ein implementierter Fehlerstatus auf der Sekundärseite von der Primärseite dadurch erkannt, dass ein Stromfluss durch die nun leitende Diode möglich ist.

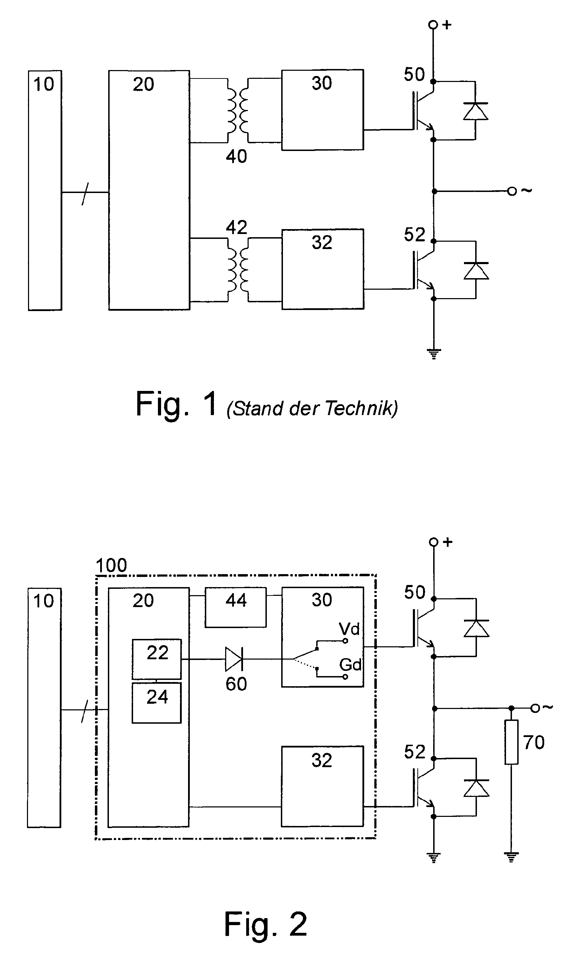

Der erfinderische Gedanke wird anhand der Ausführungsbeispiele der Fig. 1 und 2 näher erläutert.

Fig. 1 zeigt eine Schaltungsanordnung nach dem Stand der Technik.

Fig. 2 zeigt eine erfindungsgemäß weitergebildete Schaltungsanordnung.

Fig. 1 zeigt eine Schaltungsanordnung zur Ansteuerung von Leistungshalbleiterschaltern in Brückentopologie nach dem Stand der Technik. Dargestellt ist zwecks Vereinfachung nur eine Halbbrücke. Weitere Brückentopologien sind hierzu analog.

Bei der Ansteuerung von Leistungshalbleiterbauelementen (50, 52), wie IGBTs (insulated gate bipolar transistor), in einer Schaltungsanordnung in Brückentopologie, ist aufgrund der Spannungsdifferenz zwischen der übergeordneten Steuerung (10) beispielhaft in Form eines Mikrokontrollers (10) und der Primärseite (20) der Schaltungsanordnung einerseits und der Sekundärseite (30, 32) der Schaltungsanordnung und dem Leistungshalbleiterbauelement (50, 52) andererseits eine Potentialtrennung notwendig. Dem Stand der Technik entsprechend, sind verschiedenen Möglichkeiten der Potentialtrennung bekannt, beispielhaft Transformatoren (40, 42), Optokoppler, Lichtwellenleiter oder elektronische Bauelemente mit entsprechender Spannungsfestigkeit.

Bei der monolithischen Integration von Primärseite und Sekundärseite werden zur Übertragung von Steuersignalen von der Primärseite zur Sekundärseite häufig Levelshifter eingesetzt. Mit den genannten Bauelementen können Ein- und Ausschaltsignale von der Primärseite (Niederspannungsseite) auf die Sekundärseite (Hochspannungsseite) übertragen werden. Wesentlich für den störungsfreien Betrieb eines leistungselektronischen Systems ist die Kenntnis von Betriebszuständen auf der Sekundärseite, beispielhaft über die konkreten Schaltzustände des TOP- und des BOT-Schalters oder diverse Fehlerzustände.

Eine derartige Statusabfrage entsprechend einer Signalübertragung von der Sekundärseite zur Primärseite ist bei hybriden Lösungen mittels Transformatoren, bidirektionalen Optokopplern oder bidirektionalen Lichtwellenleitern möglich. Bei monolithisch integrierten Lösungen sind komplementäre Levelshifter, vorzugsweise unter Verwendung von pMOS- Hochspannungstransistoren, bekannt. Nachteil aller dieser genannten Lösungen ist, dass ein zusätzlicher Signalpfad mit zusätzlichen Kosten und / oder zusätzlichem Technologieaufwand realisiert werden muss.

Fig. 2 zeigt eine erfindungsgemäß weitergebildet, monolithisch integrierte, Schaltungsanordnung (100) zur Ansteuerung von Leistungshalbleiterschaltern (50, 52) in Brückentopologie. Hierbei ist zwischen der Primärseite (20) und der Sekundärseite (30) eine Diode angeordnet. Hierbei weist diese Diode eine Spannungsfestigkeit entsprechend der maximalen Potentialdifferenz zwischen Primär- und Sekundärseite auf. Die Anode dieser Diode wird von der Primärseite mit einer Spannung gleich der oder kleiner der lokalen Betriebsspannung beaufschlagt.

Die dem BOT- Schalter zugeordnete Sekundärseite (32) ist ohne Potentialtrennung mit der Primärseite (20) verbunden. Bei der erfindungsgemäßen Ausgestaltung der Schaltungsanordnung und des zugehörigen Verfahrens wird von einem Schaltungsteil der Primärseite (20) überwacht, inwieweit ein Strom durch die Diode (60) fließt. Solange die Sekundärseite (30) eine hohe positive Offsetspannung gegenüber der Primärseite (20) aufweist, kann kein dauerhafter Stromfluss durch die Diode (60) stattfinden. Somit können im Normalbetrieb während der Einschaltphasen des TOP-Schalters (50) keine Statussignale von der Sekundär- (20) auf die Primärseite (30) übertragen werden. Das gleiche gilt für Fehlerzustände, während derer die Sekundärseite (30) auf hohem Offsetpotential verbleibt. Befinden sich jedoch Primär- (20) und Sekundärseite (30) auf annähernd gleichem Bezugspotential, wie es im Ansteuermodus TOP- Schalter (50) in Stellung "aus" und BOT- Schalter (52) in Stellung "ein" der Fall ist, kann ein Strom durch die Diode (60) fließen. Dieser Zustand wird im Normalbetrieb zyklisch durchlaufen.

Bei integrierten oder auch hybriden Systemen mit einer eigenen sekundärseitigen Energieversorgung beispielhaft über bootstrap- Dioden ist dieser Betriebszustand sogar zwingend erforderlich und kann daher verwendet werden. Ausschlaggebend ist hier das Potential am kathodenseitigen Anschluss der Diode (60). Liegt dieser auf der Betriebsspannung (Vd) der Sekundärseite (30), tritt infolge der Dimensionierung der Spannungsregelung am anodenseitigen Anschluss kein statischer Stromfluss auf. Dieser Zustand signalisiert eine fehlerfreie Funktion der Sekundärseite (30), beispielhaft einen korrekt ausgeschalteten TOP- Schalter (50). Erkennt der sekundärseitig angeordnete Gatetreiber andererseits während der Phase eines eingeschalteten TOP- Schalters (50) einen Fehler, so wird dieser Status lokal gespeichert und der sekundärseitige Anschluss der Diode (60) an das Masse- Bezugspotential (Gd) gelegt. Im Verlauf der nächst folgenden Einschaltphase des BOT- Schalters (52) fließt ein Strom durch die Diode (60) und signalisiert den erkannten Fehlerstatus der Sekundärseite (30) an die, als Stromerfassungsschaltung (22), vorzugsweise mit nachfolgender Spannungsregelung (24) ausgebildete Fehlererfassung auf der Primärseite (20).

Ein Rücksetzen des sekundärseitigen Fehlerspeichers kann über den nächsten TOP-Einschaltpuls erfolgen, da dieser nur erzeugt wird, wenn das System den Fehler ignoriert bzw. als behoben ansieht. Eine Spannungsregelung auf der Primärseite (20) dient der Optimierung des Störabstandes zwischen transienten Umladeströmen und Durchlassströmen der Diode (60) infolge temporärer negativer Offsetspannungen gegenüber der sicheren Signalübermittlung.

Im einfachsten Fall liegt die Anode der Diode (60) direkt auf dem Potential der primärseitigen Betriebsspannung. Eine Erfassung des Flusstromes kann über Widerstands-Spannungsabfälle, Auskopplung von Stromanteilen oder andere bekannte Prinzipien stattfinden. Wichtig ist eine in Analogie zum Levelshifter angepasste Filterung der auftretenden transienten Umladeströme der Diode infolge ihrer Koppelkapazität zwischen Sekundärseite (30) und Primärseite (20).

Zusätzlich erfolgt eine Fensterung (Zeit- Phasen- Steuerung) der aktiven Überwachungsphasen der primärseitigen Fehlererfassung auf diejenigen Ansteuermuster, die eine genügend lang vorliegende Möglichkeit der Stromauswertung zulassen. Die strukturelle Einfachheit der Schaltungsanordnung sowie der Verzicht auf aktiv geschaltete Hochspannungsbauelemente macht eine robuste Implementierung möglich. Demgegenüber erweist es sich als nachteilig, dass die Auslesephasen zeitlich begrenzt sind. Somit ist das Verfahren nicht vollkommen universell sondern nur während der Ausschaltphasen des TOP- Schalters (50) für eine Fehler-Rückübertragung geeignet. Andererseits ist somit bei sehr geringem Kostenaufwand eine Rückmeldung in das Systeme integrierbar.

Generell ist die vorgeschlagene Methode anwendbar bei zyklischem Durchlaufen der Schaltzustände einer Brückenschaltung. Im beispielhaften Anwendungsfall einer Betriebsspannungsüberwachung der Sekundärseite (30) muss mittels der Dimensionierung der kapazitiven Blockung sichergestellt werden, dass die Spannung nach Unterschreiten der Betriebsspannungschwelle noch bis zur nächsten Schaltphase einen ausreichenden Wert behält. Durch die genannte Schaltungsanordnung und das zugehörige Verfahren wird der lokal zwischengespeicherte Fehlerstatus von der Sekundärseite auf die Primärseite übertragen und ein erneutes Einschalten des TOP- Schalters (50) im Fehlerfall somit vermieden.

Bei Schaltzuständen, bei denen beide Schalter ausgeschaltet sind, ist das Bezugspotential nicht definiert sondern schwebend, so dass keine sichere Rückübermittlung stattfinden kann. Um auch in solchen Fällen eine Fehlerübertragung zu gewährleisten wird mittels eines hochohmigen Widerstandes (70) der Wechselstromabgriff der Brückenschaltung mit dem Masse- Bezugspotential hochohmig verbunden, indem der BOT- Schalter hochohmig überbrückt wird.. Bei der Dimensionierung des Widerstandes muss der Querstrom im regulären Betrieb beachtet werden. Dieser Strom soll einerseits minimal sein, andererseits aber ausreichend, um die Koppelkapazität des gesamten Brückenausganges zu entladen.

## Patentansprüche

1. Schaltungsanordnung (100), vorzugsweise monolithisch integriert, zur Ansteuerung von Leistungshalbleiterschaltern (50, 52) in Brückentopologie bestehend aus einem primärseitigen Teil (Primärseite, 20) und jeweils einem sekundärseitigen Teil (Sekundärseite, 30) für den TOP- (50) und den BOT- Schalter (52) der Brückenschaltung, wobei die Primärseite (20) mindestens eine Signalverarbeitung und mindestens einen Levelshifter (44) zur potentialfreien Ansteuerung mindestens einer Sekundärseite (30) aufweist und diese Sekundärseite (30) mindestens eine Signalverarbeitung sowie mindestens eine Treiberstufe für den jeweiligen Schalter aufweist, wobei zwischen der Primärseite (20) und mindestens einer Sekundärseite (30) eine Diode (60) zur Fehlerstatusübermittlung von der Sekundärseite (30) zur Primärseite (20) angeordnet ist, deren anodenseitiger Anschluss zur Primärseite (20) und deren kathodenseitiger Anschluss zur Sekundärseite (30) der Treiberschaltung angeordnet ist, diese Diode (60) auf der Primärseite (20) mit einer Filterung und einer Stromerfassung zur Fehlerstatuserkennung verbunden ist und auf der Sekundärseite (30) mit einer Schaltung zur Fehlerstatusimplementierung verbunden ist.

2. Schaltungsanordnung nach Anspruch 1,
wobei der Mittenabgriff der Brückenschaltung und somit auch die Schaltung zur Fehlerstatusimplementierung mit dem Masse- Bezugspotential der gesamten Schaltungsanordnung über einen hochohmigen Widerstand (70) verbunden ist.

3. Schaltungsanordnung nach Anspruch 1,
wobei die Diode eine Spannungsfestigkeit entsprechend der maximalen Potentialdifferenz zwischen Primär- (20) und Sekundärseite (30) aufweist.

4. Verfahren zur Fehlerübermittlung von der Sekundärseite (30) zur Primärseite (20) in einer Schaltungsanordnung nach Anspruch 1 oder 2,
wobei von der Primärseite (20) eine definierte Spannung, gleich oder kleiner als die dortige Betriebsspannung, an die Anode der Diode (60) angelegt wird und bei fehlerfreiem Betrieb der einem TOP- Schalter (50) zugeordneten Sekundärseite (30) mittels der Fehlerstatusimplementierungsschaltung die Katode der Diode "high-" Pegel (Vd) aufweist, bei fehlerhaftem Betrieb mittels der Fehlerstatusimplementierung "low-" Pegel (Vg) aufweist, und bei geschlossenem TOP- Schalter (50) ein Fehlerstatus auf der Sekundärseite (30) von der Primärseite (20) **dadurch** erkannt wird, weil ein Stromfluss durch die Diode (60) stattfindet, da sich der sekundärseitige "low-" Pegel über den geöffneten BOT- Schalter (52) oder über den hochohmigen Widerstand (70) annähernd auf dem Masse- Bezugspotential befindet.

5. Verfahren nach Anspruch 4,
wobei der Stromfluss über die Diode (60) nach einer Filterung und einer Zeit- PhasenSteuerung mittels Erfassung des Widerstandsspannungsabfalls infolge Stromfluss oder der Auskopplung von Stromanteilen ausgewertet wird.
